# DEMANDE DE BREVET EUROPEEN

(11) **EP 0 633 713 A1**
(43) Date de publication de la demande: **11.01.1995**
(21) Numéro de dépôt: 94401485.1
(22) Date de dépôt: 30.06.1994
(51) Int. Cl.: H05H 1/46, H01J 37/32

(54) **Réacteur à plasma pour un procédé de dépôt ou de gravure**

(30) Priorité: 05.07.1993 FR 9308204
(71) Demandeur: ALCATEL CIT, F-75008 Paris (FR)
(72) Inventeur: Pearson, David, F-74000 Annecy (FR)
(74) Mandataire: Gosse, Michel

(57) **Abrégé**

Réacteur à plasma pour un procédé de dépôt ou de gravure comportant une enceinte à vide (1) destinée à recevoir un substrat (5) à traiter, et comportant des moyens (3) pour l'introduction d'un gaz à ioniser, le plasma étant excité par une antenne (8) alimentée par un générateur de puissance radio-fréquence (14), ladite antenne étant composée d'un conducteur (9) électrique se développant dans un plan parallèle audit substrat à traiter, caractérisé en ce que dans ledit plan, le conducteur (9) d'antenne chemine selon une pluralité, au moins trois, d'aller (10) et retour (11) dans des sens alternativement opposés.

## Description

La présente invention concerne un réacteur à plasma pour un procédé de dépôt ou de gravure.

On sait que dans de telles machines, celles du type à excitateur inductif de plasma, permettent d'obtenir une densité ionique beaucoup plus élevée, de l'ordre de 100 fois, que celles du type à excitation capacitive.

On connaît par le document EP 0 413 282 une machine du type à excitateur inductif dans laquelle l'antenne excitatrice est plane et a la forme d'un serpentin enroulé en spirale.

Cette disposition, pour la source excitative, assure une bonne uniformité ionique. Par rapport aux autres sources inductives connues, elle assure une meilleure uniformité à haute pression (supérieure à 10⁻² mbar). Elle assure également, vis-à-vis des autres sources inductives connues, une meilleure densité ionique lors de l'utilisation de gaz électronégatifs, tels que SF₆, C₂F₆, Cl₂ pour lesquels la densité ionique chute rapidement en fonction de la pression et la séparation source-substrat dans les autres sources connues. Or, de tels gaz sont typiquement utilisés à haute pression supérieure à 10⁻² mbar en gravure profonde et rapide.

Cependant, avec une telle antenne comme source excitative de plasma, le champ électromagnétique est relativement élevé à une distance éloignée de l'antenne procurant une forte énergie aux particules ionisées, ce qui, dans le cas de gravure, peut endommager le substrat à graver.

La présente invention a pour but de pallier cet inconvénient et a pour objet un réacteur à plasma pour un procédé de dépôt ou de gravure comportant une enceinte à vide destinée à recevoir un substrat à traiter et comportant des moyens pour l'introduction d'un gaz à ioniser, le plasma étant excité par une antenne alimentée par un générateur de puissance radio-fréquence, ladite antenne étant composée d'un conducteur électrique se développant dans un plan parallèle audit substrat à traiter, caractérisé en ce que, dans ledit plan, le conducteur d'antenne chemine selon une pluralité, au moins trois, d'aller et retour dans des sens alternativement opposés.

Selon une autre caractéristique, ledit générateur de puissance radio-fréquence alimente ladite antenne par l'intermédiaire d'un circuit d'adaptation comportant un premier condensateur variable relié en série à un second condensateur variable monté en parallèle aux bornes de ladite antenne.

D'autres caractéristiques de la présente invention ressortiront de la description d'un exemple de mise en oeuvre de l'invention faite ci-après en regard du dessin annexé dans lequel :

La figure 1 représente schématiquement un réacteur à plasma selon l'invention.

La figure 2 montre, en vue agrandie, l'antenne excitatrice selon l'invention.

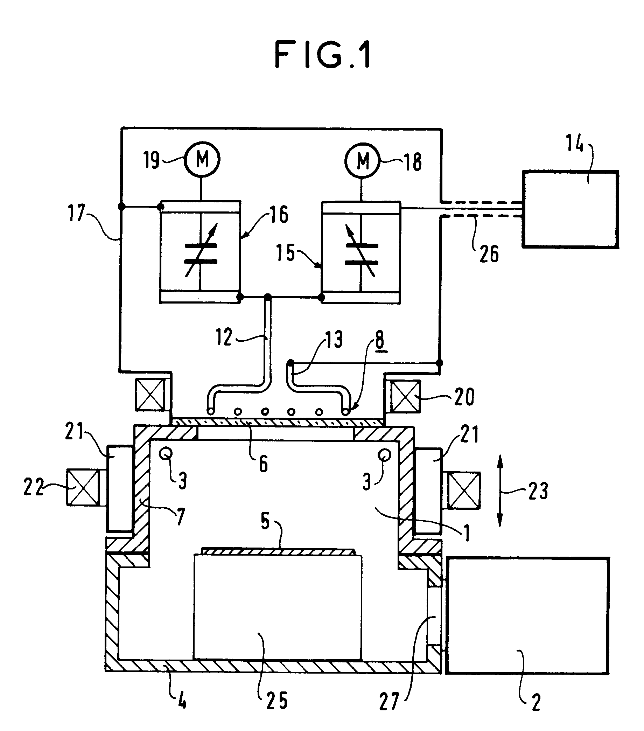

En se référant à la figure 1, le réacteur à plasma comprend essentiellement une enceinte à vide 1 pompée par un groupe de pompage 2. Des trous 3 permettent l'introduction d'un gaz de traitement à ioniser par exemple du SF₆, C₂F₆, Cl₂, etc....

L'enceinte est fermée à sa partie inférieure par un compartiment inférieur 4 comportant un orifice 27 pour la liaison avec ledit groupe de pompage 2. Ce compartiment inférieur 4 est équipé d'un porte-sbstrat 25 qui, selon le procédé de traitement envisagé (dépôt ou gravure), peut permettre la polarisation, le chauffage ou le refroidissement du substrat 5 ainsi que son positionnement vertical.

A sa partie supérieure, l'enceinte est fermée par un hublot 6 en quartz ou en un autre matériau diélectrique compatible avec le traitement. La paroi latérale 7 de l'enceinte 1 est en matériau conducteur amagnétique.

La source d'excitation, pour générer dans l'enceinte 1 le plasma, est constituée par une antenne 8 disposée sur le hublot 6.

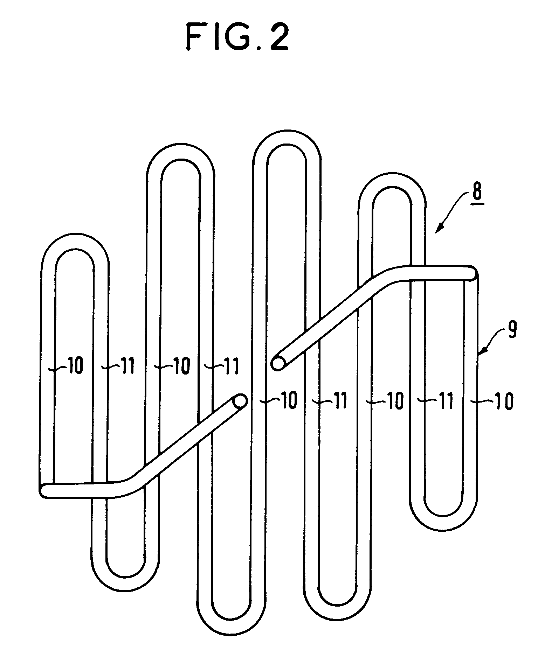

Cette antenne est composée d'un conducteur électrique 9 qui se développe dans un plan parallèle au plan du substrat 5 et, conformément à l'invention, le conducteur 9 d'antenne, comme le montre en vue agrandie la figure 2, chemine dans son plan selon une pluralité d'aller 10 et retour 11 dans des sens alternativement opposés formant ainsi des méandres.

L'antenne 8 est reliée, par deux amenées rapprochées de courant 12 et 13 perpendiculaires au hublot 6 à un générateur de puissance radio-fréquence 14 à 13,56 MHz par l'intermédiaire d'un circuit d'adaptation comportant un premier condensateur variable 15 relié directement au générateur 14 et relié en série à une borne d'un second condensateur variable 16, monté en parallèle aux bornes de l'antenne 8, et dont la deuxième borne est reliée au retour 26 du générateur radio-fréquence 14 qui est électriquement relié au châssis 17 formant masse. Les condensateurs variables 15 et 16 sont réglés par des moteurs 18 et 19 commandés par un circuit d'adaptation automatique ou manuelle.

Autour de l'antenne 8 est placée une première bobine électrique 20 de façon à produire un champ magnétique perpendiculaire au plan de l'antenne 8.

Tout autour de l'enceinte 1 sont en outre disposés des aimants permanents 21 polarisés radialement et successivement en sens inverse les uns des autres de façon à former un champ de confinement "multi-polaire" pour le plasma.

Enfin, une deuxième bobine électrique 22 est en outre disposée autour de l'enceinte 1 de façon à produire un champ magnétique perpendiculaire à un plan situé entre le hublot et le substrat 5 et parallèle à ce dernier. Le positionnement de cette bobine 22 est réglable comme le figure la flèche à double sens 23. Les bobines 20 et 22, alimentées en courant continu, servent à optimiser l'intensité et l'uniformité du plasma et du procédé au niveau du substrat 5.

Grâce aux allers et retours 10, 11 de l'antenne 8, l'inductance de l'antenne est réduite de façon significative par rapport à l'antenne en spirale du document antérieur cité en introduction. Il en résulte un champ électromagnétique très faible dès que l'on s'écarte de l'antenne d'une distance supérieure à la distance séparant un aller 10 d'un retour 11 et l'énergie des particules chargées dans le plasma au niveau du substrat 5 est ainsi minimisée.

La présence du champ magnétique statique produit par les bobines 20, 22 permet de générer des ondes résonnantes stationnaires dans le plasma qui augmentent le rendement et l'efficacité de couplage de l'énergie radio-fréquence aux électrons du plasma. L'énergie des électrons, qui seront thermalisés, est transférée au plasma par des collisions d'où la forte densité ionique.

Le plasma produit par le réacteur à plasma de l'invention peut être utilisé pour les procédés de gravure ioniques réactive et sélective, de nettoyage par pulvérisation ou de dépôt PECVD (Plasma enhance chemical vapour deposition) de couches minces sur le substrat.

## Revendications

**1/** Réacteur à plasma pour un procédé de dépôt ou de gravure comportant une enceinte à vide (1) destinée à recevoir un substrat (5) à traiter, et comportant des moyens (3) pour l'introduction d'un gaz à ioniser, le plasma étant excité par une antenne (8) alimentée par un générateur de puissance radio-fréquence (14), ladite antenne étant composée d'un conducteur (9) électrique se développant dans un plan parallèle audit substrat à traiter, caractérisé en ce que dans ledit plan, le conducteur (9) d'antenne chemine selon une pluralité, au moins trois, d'aller (10) et retour (11) dans des sens alternativement opposés.

**2/** Réacteur à plasma selon la revendication 1, caractérisé en ce que ledit générateur de puissance radio-fréquence (14) alimente ladite antenne (8) par l'intermédiaire d'un circuit d'adaptation comportant un premier condensateur variable (15) relié en série à un second condensateur variable (16) monté en parallèle aux bornes de ladite antenne (8).

**3/** Réacteur à plasma selon l'une des revendications 1 ou 2, caractérisé en ce qu'une pluralité d'aimants permanents (21) est disposée autour de ladite enceinte (1) à vide, lesdits aimants (21) étant polarisés radialement et successivement en sens inverse les uns des autres.

**4/** Réacteur à plasma selon l'une des revendications précédentes, caractérisé en ce qu'une bobine électrique (22), alimentée en courant continu, est disposée autour de ladite enceinte (1), l'axe de ladite bobine étant perpendiculaire au plan de ladite antenne (8), ladite bobine étant réglable en position le long dudit axe.

**5/** Réacteur à plasma selon l'une des revendications précédentes, caractérisé en ce qu'une bobine électrique (20), alimentée en courant continu, est disposée autour de ladite antenne (8), l'axe de ladite bobine (20) étant perpendiculaire au plan de l'antenne (8).
